# EUROPEAN PATENT APPLICATION

(11) **EP 2 945 042 A1**
(43) Date of publication of application: **18.11.2015**
(21) Application number: 15165323.5
(22) Date of filing: 28.04.2015
(51) Int. Cl.: G06F 1/30

(54) **ELECTRONIC DEVICE WITH MEMORY DATA BACKUP FUNCTION**

(30) Priority: 12.05.2014 KR 20140056610
(71) Applicant: LSIS Co., Ltd., Anyang-si, Gyeonggi-do 431-848 (KR)
(72) Inventor: Oh, Joon Seok, 435-871 Gyeonggi-do (KR); Kim, Ki Myung, 435-838 Gyeonggi-do (KR)
(74) Representative: Groth & Co. KB

(57) **Abstract**

An electronic device with data backup function is disclosed. The electronic may include: a main memory; a controller; a main power supply unit configured to supply a main electric power to the controller and the main memory; an auxiliary power supply unit configured to supply an auxiliary electric power to the controller and the main memory; and a power supply monitoring unit configured, by monitoring a state of the main electric power, to transmit either a normality detection signal or an abnormality detection signal to the controller, and to apply either the main electric power or the auxiliary electric power to the controller and the main memory, according to the state of the main electric power, wherein the controller backs up the data stored in the main memory and an operation state of the controller itself to an auxiliary memory, when receiving the abnormality detection signal.

## Description

### BACKGROUND

### FIELD OF THE DISCLOSURE

The present disclosure relates to an electronic device with memory data backup function. More particularly, the present disclosure relates to an electronic device with memory data backup function configured to back up data stored in a main memory to an auxiliary memory by using an auxiliary electric power supply, when electric power of a main electric power supply is insufficiently supplied.

### DISCUSSION OF THE RELATED ART

Most of recently-used electronic/electric devices are installed with MCUs (Microprocessor Control Units). Each of the MCUs includes a memory, and the memory stores data to be processed by the MCU and a result of the process by the MCU.

However, the data to be referred by the MCU is often lost or falsified in a volatile memory, due to unexpected abnormality of power source.

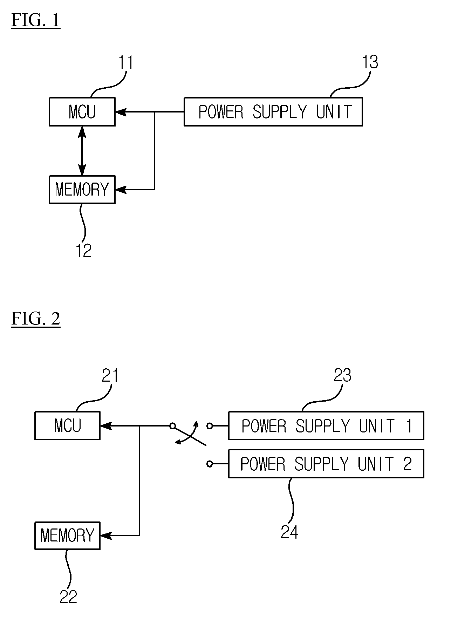

FIG. 1 is a block diagram of a conventional electronic device with no backup means. As illustrated in FIG. 1, in the conventional electronic device, an MCU (11) and a memory (12) operate by being provided with an electric power supply from a power supply unit (13), and the MCU (11) operates by using data stored in the memory (12).

At this moment, when the power supply unit (13) fails to normally supply electrical power to the MCU (11) and the memory (12) due to an instantaneous occurrence of power outage, for example, when the power supply is completely failed or when the electric power is supplied above or below a reference voltage, the values or addresses in the memory (12), to which the MCU must refer, may be lost or falsified, by change in voltage level at a circuit.

Thus, the MCU (11) may be rendered to be inoperable, and in the case of a control system, a critical safety problem may be generated.

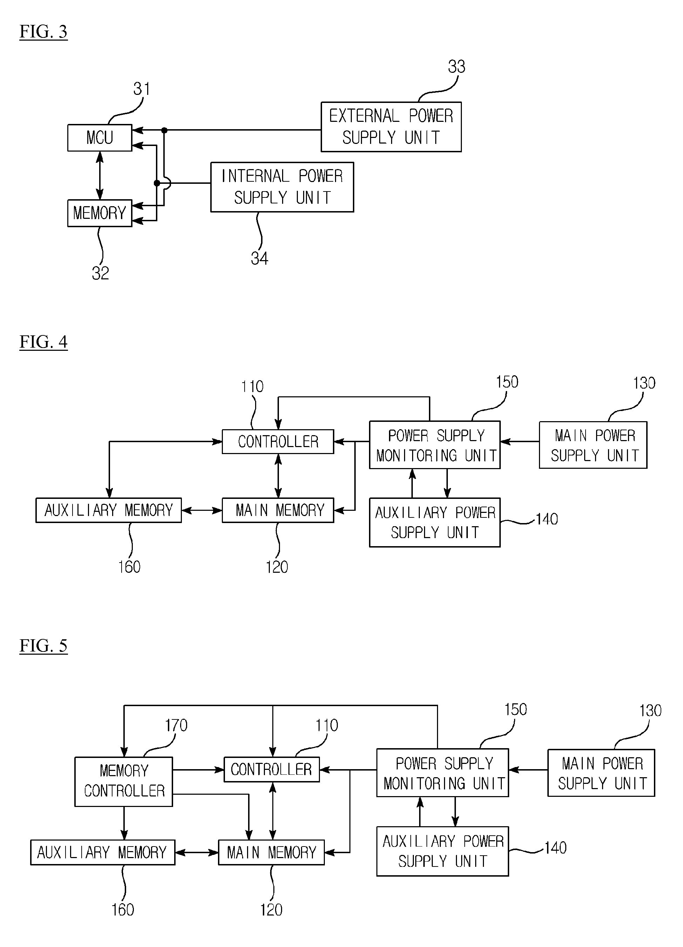

In order to solve such problem, as illustrated in FIG. 2, an electronic device configured to have two power supply units (23,24) to supply an electric power to the MCU (21) and the memory (22) is proposed. In addition, as illustrated in FIG. 3, it is proposed an electronic device where: the MCU (31) and the memory (32) operates by being supplied with electronic power from an external power supply unit (33) in a normal state; and the MCU (31) and the memory (32) operate by being supplied with electronic power from an internal power supply unit (34) in a power failure.

However, there is a limitation in the structure as illustrated in FIG. 2 that only the supply of electric power is considered, but that the change of electric power quality is not considered.

In addition, the structure illustrated in FIG. 3 is approached from a viewpoint similar to that of duplication of power supply system. Thus, the structure has limitations of being unable to respond to the problems occurring when the electric power is supplied above a reference voltage for circuit operation, nor to the potential problems occurring in an abnormal state of main electric power supply unit to applied electric power to the external and internal power supply units (33, 34).

### SUMMARY OF THE DISCLOSURE

The present disclosure is proposed to solve out the problems of conventional art as in the above. An object of the present disclosure is to provide an electronic device with memory data backup function, which is configured to back up data stored in the main memory to an auxiliary memory by using an auxiliary power supply unit, when a main electric power is not supplied normally.

In a general aspect of the present disclosure, there is provided an electronic device with memory data backup function including a main memory and a controller to perform an operation by using data stored in the main memory, the electronic device with memory data backup function comprising: a main power supply unit configured to supply a main electric power to the controller and the main memory; an auxiliary power supply unit configured to supply an auxiliary electric power to the controller and the main memory; and a power supply monitoring unit configured, by monitoring a state of the main electric power, to transmit either a normality detection signal or an abnormality detection signal to the controller, and to apply either the main electric power or the auxiliary electric power to the controller and the main memory, according to the state of the main electric power, wherein the controller backs up the data stored in the main memory and an operation state of the controller itself to an auxiliary memory, when receiving the abnormality detection signal.

In some exemplary embodiments of the present disclosure, the power supply monitoring unit may apply the auxiliary electric power to the controller and the main memory, and may transmit the abnormality detection signal to the controller, when detecting an abnormal change in electric power of the main electric power.

In some exemplary embodiments of the present disclosure, the power supply monitoring unit may apply the main electric power to the controller and the main memory, and may transmit the normality detection signal to the controller, when detecting a normal electric power supply of the main electric power.

In some exemplary embodiments of the present disclosure, the controller may restore the data backed up in the auxiliary memory to the main memory, and may operate by receiving the operation state, when receiving the normality detection signal.

In some exemplary embodiments of the present disclosure, the power supply monitoring unit may charge the auxiliary power supply unit by applying the main electric power to the auxiliary power supply unit, when a charged amount is lower than a charge reference, by measuring the charged amount of the auxiliary power supply unit.

In some exemplary embodiments of the present disclosure, the controller and the main memory may operate by being supplied with the main electric power in an initial operation stage of the electronic device, and the power supply monitoring unit may render the auxiliary electric power to be supplied to the controller and the main memory, and may monitor whether the main electric power is normally supplied by consistently checking a supply state of the main electric power, when detecting an abnormal change in electric power of the main electric power.

In some exemplary embodiments of the present disclosure, the main memory may be a volatile memory, and the auxiliary memory may be a non-volatile memory.

In some exemplary embodiments of the present disclosure, the controller may back up the data stored in the main memory and an operation state of the controller itself to the auxiliary memory, by operating by being supplied with the auxiliary electric power.

In some exemplary embodiments of the present disclosure, the power supply monitoring unit may detect as an abnormal change in electric power, when the main electric power is not supplied, or the main electric power is above or below a reference voltage.

In some exemplary embodiments of the present disclosure, the controller may include: a first controller configured to perform an operation by using data stored in the main memory; and a second controller configured to back up the data stored in the main memory and an operation state of the first controller itself to the auxiliary memory, when receiving the abnormality detection signal.

In some exemplary embodiments of the present disclosure, the second controller, when receiving the normality detection signal, may restore the data backed up in the auxiliary memory to the main memory, and may enable the first controller to continuously perform an operation in a state before backup by providing the first controller with the stored operation state.

According to an exemplary embodiment of the present disclosure, lost or falsification of data stored in the main memory may be prevented, by monitoring electric power supplied from the main power supply unit, by backing up the data stored in the main memory to the auxiliary memory, when detecting an abnormality in the power supply.

In addition, the device may immediately return to the normal state by receiving the operation state, as soon as the main electric power supply is restored, because the operation state of the controller is stored in the auxiliary memory as well as the data stored in the main memory.

### BRIEF DESCRIPTION OF THE DRAWINGS

FIGS. 1 to 3 are block diagrams of a conventional electronic device.
FIG. 4 is a block diagram of an electronic device with memory data backup function according to a first exemplary embodiment of the present disclosure.
FIG. 5 is a block diagram of an electronic device with memory data backup function according to a second exemplary embodiment of the present disclosure.
FIG. 6 is an operation flow chart of an electronic device with memory data backup function according to a first exemplary embodiment of the present disclosure.

### DETAILED DESCRIPTION

Hereinafter, referring to enclosed figures, exemplary embodiment of the present disclosure will be described in detail so that persons skilled in the art may make and use the same. The thickness of lines and the size of components illustrated in the drawings may be exaggerated herein for clear and convenient description. In addition, terms to be mentioned in the following are defined in consideration of functions in the present disclosure, which may be varied according to the intention of a user or an operator, or practical customs. Therefore, the definition of the terms shall be made based on the overall contents of the present disclosure.

FIG. 4 is a block diagram of an electronic device with memory data backup function according to a first exemplary embodiment of the present disclosure.

Referring to FIG. 4, the electronic device (100) according to a first exemplary embodiment of the present disclosure may include a controller (100), a main memory (120), a main power supply unit (130), an auxiliary power supply unit (140), a power supply monitoring unit (150), and an auxiliary memory (160).

The main memory (120) stores various data for operating the electronic device (100). The controller (110) may operate by using the data stored in the main memory (120), and may store data which is generated during the operation or as a result of the operation to the main memory (120).

The main memory (120) may be a volatile memory, and the auxiliary memory (160) may be a non-volatile memory. As the non-volatile memory, for example, a flash memory, a phase-change memory (PCM), a resistive random access memory (RRAM), a ferroelectrics memory, and an M RAM may be used, but not limited hereto. The flash memory may be, for example, a NAND flash memory, but not limited hereto.

Meanwhile, the main power supply unit (130) may be an external electric power supply (not illustrated in the figure) such as a household electricity supplied through an electric power line or an electric power supply, where the household electricity is converted to be appropriate for electric devices.

In addition, the auxiliary power supply unit (140) may be, for example, a super capacitor, a lithium-ion battery, a nickel-cadmium battery, or a Nickel Metal Hydride (Ni-MH) Battery.

Here, the auxiliary power supply unit (140) may supply electric power required for backing up the data stored in the main memory (120) to the auxiliary memory (160), as to be described in the following.

In addition, the main power supply unit (130) may be an external power supply device to supply electric power from outside of the electric device (100), and the auxiliary power supply unit (140) may be an internal power supply device to supply electric power from inside of the electric device (100).

In addition, the auxiliary power supply unit (140) may be charged by using electric power supplied from the main power supply unit (130).

The controller (110) and the main memory (120) may operate by being applied with electric power from the main power supply unit (130). In addition, the controller (110) and the main memory (120) may operate by being applied with electric power from the auxiliary power supply unit (140).

In addition, the auxiliary memory (160) may operate by being applied with electric power from the auxiliary power supply unit (140), or otherwise, may operate by being applied with electric power from a separate power supply unit. That is, the auxiliary memory (160) may be supplied with electric power from a power supply path different from that of the controller (110) and the main memory (120).

Here, the controller (110) and the main memory (120) may operate by being applied with electric power from the main power supply unit (130) in a normal state, for example, when the electric power is normally applied from the main power supply unit (130).

When the electric power supplied from the main power supply unit (130) is abnormal, for example, when the electric power is not supplied, or the electric power is above or below a reference voltage, the controller (110) and the main memory (120) may operate by being applied with electric power from the auxiliary power supply unit (140).

The power supply monitoring unit (150) may block the electric power supplied from the main power supply unit (130) to be applied to the controller (110) and the main memory (120), and may apply the electric power supplied from the auxiliary power supply unit (140) to the controller (110) and the main memory (120), by monitoring a state of the main electric power supplied from the main power supply unit (130), when detecting an abnormal change in electric power.

Here, the abnormal change in electric power is an unexpected change in the electric power supply, for example, such as a case when the electric power is not supplied from the main power supply unit (130), or the electric power supplied from the main power supply unit (130) is above or below a reference voltage.

In addition, the power supply monitoring unit (150) may transmit an abnormality detection signal to the controller (110), when detecting an abnormal change in electric power.

That is, the power supply monitoring unit (150), when detecting an abnormal change in electric power, may block the electric power supplied from the main power supply unit (130) to be applied to the controller (110) and the main memory (120), may apply the electric power supplied from the auxiliary power supply unit (140) to the controller (110) and the main memory (120), and may transmit an abnormality detection signal to the controller (110).

At this moment, the power supply monitoring unit (150) may continuously monitor the electric power supplied from the main power supply unit (130), even after blocking the electric power supplied from the main power supply unit (130) to be applied to the controller (110) and the main memory (120).

In addition, the power supply monitoring unit (150) may convert the main agent for supplying electric power to the controller (110) and the main memory (120) from the auxiliary power supply unit (140) to the main power supply unit (130), when determining that the electric power supplied from the main power supply unit (130) is normal, after the conversion of the main agent for supplying electric power by detecting the abnormal change in electric power.

That is, the power supply monitoring unit (150) may block the electric power supplied from the auxiliary power supply unit (140) to be applied to the controller (110) and the main memory (120), and may render the electric power supplied from the main power supply unit (130) to be applied to the controller (110) and the main memory (120).

Meanwhile, the auxiliary memory (160) may operate by being applied with electric power from the main power supply unit (130), or otherwise, may operate by being applied with electric power from a separate power supply unit. That is, the auxiliary memory (160) may be supplied with electric power from a power supply path different from that of the controller (110) and the main memory (120).

In addition, the power supply monitoring unit (150) may transmit a normality detection signal to the controller (110), when detecting a normal electric power supply.

In addition, the power supply monitoring unit (150) may charge the auxiliary power supply unit (140) by applying the electric power supplied from the main power supply unit (130) to the auxiliary power supply unit (140), when a charged amount is lower than a charge reference, by measuring the charged amount of the auxiliary power supply unit (140).

Meanwhile, the controller (110) may stop the current operation and back up the data stored in the main memory (120) to the auxiliary memory (160), when receiving the abnormality detection signal transmitted from the power supply monitoring unit (150). In addition, the controller (110) may store the current operation state of the controller (110) itself to the auxiliary memory (160).

In addition, the controller (110) may restore the data backed up in the auxiliary memory (160) to the main memory (120), and may operate based on the operation state stored in the auxiliary memory (160) by being provided with the operation state, when receiving the normality detection signal transmitted from the power supply monitoring unit (150).

According to the first exemplary embodiment of the present disclosure described in the above, the controller (110) may take charge of delivering the data between the main memory (120) and the auxiliary memory (130), by receiving either an abnormality detection signal or a normality detection signal from the power supply monitoring unit (150).

Instead, apart from the controller (110), a separately added memory controller may back up the data stored in the main memory (120) to the auxiliary memory (160), or may restore the data backed up in the auxiliary memory (160) to the main memory (120), by receiving either an abnormality detection signal or a normality detection signal from the power supply monitoring unit (150).

Hereinafter, referring to FIG. 5, a second exemplary embodiment of the present disclosure will be described. However, the same reference numerals will be given to the same structure as illustrated in FIG. 4, and the detailed description thereof will not be repeated.

As illustrated in FIG. 5, the electronic device according to a second exemplary embodiment of the present disclosure may further include a memory controller (170) in addition to the structure of the first exemplary embodiment of the present disclosure.

The power supply monitoring unit (150) may transmit an abnormality detection signal to the controller (110) and the memory controller (170), when detecting an abnormal change in electric power, by monitoring a state of the main electric power supplied from the main power supply unit (130).

The controller (110) may stop the current operation when receiving the abnormality detection signal. And the memory controller (170) may back up the data stored in the main memory (120) to the auxiliary memory (160), and may store the current operation state of the controller (110) to the auxiliary memory (160), by receiving the abnormality detection signal.

In addition, the power supply monitoring unit (150) may convert the main agent for supplying electric power to the controller (110) and the main memory (120) from the auxiliary power supply unit (140) to the main power supply unit (130), according to the detected abnormality. Afterwards, the power supply monitoring unit (150) may convert the main agent for supplying electric power to the controller (110) and the main memory (120) from the auxiliary power supply unit (140) to the main power supply unit (130), when determining that the electric power supplied from the main power supply unit (130) is normal, by continuously monitoring the electric power supplied from the main power supply unit (130).

In addition, the power supply monitoring unit (150) may transmit a normality detection signal to the controller (110) and the memory controller (170), when detecting a normal electric power supply.

The memory controller (170) may restore the data backed up in the auxiliary memory (160) to the main memory (120), and may transmit the operation state of the controller (110), which is stored by being provided from the controller (110), to the controller (110), when receiving the normality detection signal.

Meanwhile, the memory controller (170) may operate by being applied with electric power from the main power supply unit (130) or the auxiliary power supply unit (140), or otherwise, may operate by being applied with electric power from a separate power supply unit. That is, the memory controller (170) may be supplied with electric power from a power supply path different from that of the controller (110) and the main memory (120).

In addition, the memory controller (170) may be supplied with electric power from a power supply unit same with that of the auxiliary memory (160), or otherwise, may be supplied with electric power from a power supply unit different from that of the auxiliary memory (160).

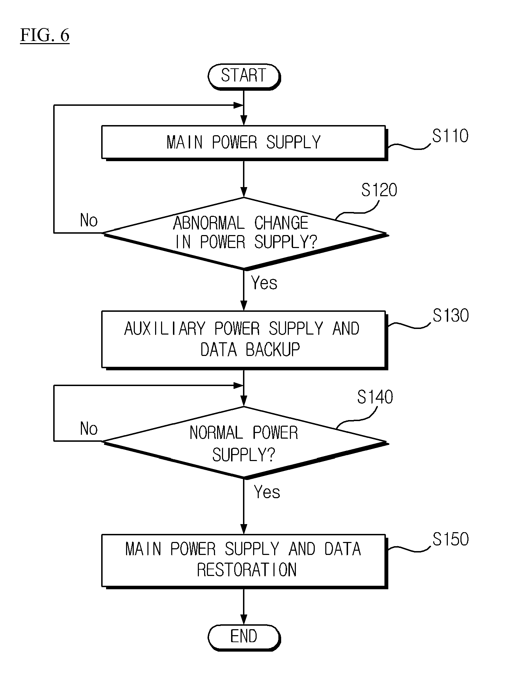

FIG. 6 is an operation flow chart of an electronic device with memory data backup function according to a first exemplary embodiment of the present disclosure.

Referring to FIG. 6, the electronic device may operate by being applied with the main electric power from the main power supply unit (130) at an initial operation stage, and the main electric power is supplied to the controller (110) and the main memory (120) (S110).

When the power supply unit (150) detects an abnormal change in the main electric power during operating by the main electric power (S120-Yes), the power supply unit (150) may block the main electric power supply, and may supply the auxiliary electric power from the auxiliary power supply unit (140) to the controller (110) and the main memory (120), and the controller (110) may stop the operation and back up the data stored in the main memory (120) and an operation state of the controller (110) itself to the auxiliary memory (160)(S130).

After the step S130, the power supply unit (150) may monitor and determine whether the main electric power is normally supplied by consistently checking a supply state of the main electric power (S140).

As a result according to determination of the step S140, when determining that a normal electric power is supplied (S140-Yes), the power supply unit (150) may block the auxiliary electric power supply, and may supply the main electric power from the main power supply unit (130) to the controller (110) and the main memory (120), and the controller (110) may restore the data backed up in the auxiliary memory (160) to the main memory (120), and may operate by being provided with the operation state (S150).

According to an exemplary embodiment of the present disclose described in the above, lost or falsification of data stored in the main memory due to an abnormal power supply may be prevented, by monitoring electric power supplied from the main power supply unit, and by blocking the main electric power and backing up the data stored in the main memory to the auxiliary memory using the auxiliary electric power supplied from the auxiliary power supply unit, when detecting an abnormality in the power supply.

In addition, the device may immediately return to the normal operating state at the time point when the main electric power was blocked, by receiving the operation state, as soon as the main electric power is normally supplied, because the operation state of the controller is stored in the auxiliary memory simultaneously when the data stored in the main memory is stored in the auxiliary memory.

Meanwhile, although exemplary embodiments of the present disclosure have been described in the above, however, the scope of the present disclosure is not limited by the embodiments described above. Therefore, the present disclosure may be alternatively performed in various transformation or modifications within the limit such that the differences are obvious to persons having ordinary skill in the art to which the present disclosure pertains.

Therefore, the abovementioned exemplary embodiments and enclosed figures are intended to be illustrative, and not to limit the scope of the claims. The scope of protection of the present disclosure is to be interpreted by the following claims, and that all the technical ideas within the equivalent scope of the scope of the present disclosure should be construed as being included.

## Claims

1. An electronic device with memory data backup function including a main memory (120) and a controller (110) to perform an operation by using data stored in the main memory (120), the electronic device with memory data backup function comprising:
a main power supply unit (130) configured to supply a main electric power to the controller (110) and the main memory (120);
an auxiliary power supply unit (140) configured to supply an auxiliary electric power to the controller (110) and the main memory (120); and
a power supply monitoring unit (150) configured, by monitoring a state of the main electric power, to transmit either a normality detection signal or an abnormality detection signal to the controller (110), and to apply either the main electric power or the auxiliary electric power to the controller (110) and the main memory (120), according to the state of the main electric power,
wherein the controller (110) backs up the data stored in the main memory (120) and an operation state of the controller (110) itself to an auxiliary memory (160), when receiving the abnormality detection signal.

2. The electronic device with memory data backup function of claim 1, wherein
the power supply monitoring unit (150) applies the auxiliary electric power to the controller (110) and the main memory (120), and transmits the abnormality detection signal to the controller (110), when detecting an abnormal change in electric power of the main electric power.

3. The electronic device with memory data backup function of claim 1 or 2, wherein
the power supply monitoring unit (150) applies the main electric power to the controller (110) and the main memory (120), and transmits the normality detection signal to the controller (110), when detecting a normal electric power supply of the main electric power.

4. The electronic device with memory data backup function of any one of claims 1 to 3, wherein
the controller (110) restores the data backed up in the auxiliary memory (160) to the main memory (120), and operates by receiving the operation state, when receiving the normality detection signal.

5. The electronic device with memory data backup function of any one of claims 1 to 4, wherein
the power supply monitoring unit (150) charges the auxiliary power supply unit (140) by applying the main electric power to the auxiliary power supply unit (140), when a charged amount is lower than a charge reference, by measuring the charged amount of the auxiliary power supply unit (140).

6. The electronic device with memory data backup function of any one of claims 1 to 5, wherein
the controller (110) and the main memory (120) operate by being supplied with the main electric power in an initial operation stage of the electronic device, and
the power supply monitoring unit (150) renders the auxiliary electric power to be supplied to the controller (110) and the main memory (120), and monitors whether the main electric power is normally supplied by consistently checking a supply state of the main electric power, when detecting an abnormal change in electric power of the main electric power.

7. The electronic device with memory data backup function of any one of claims 1 to 6, wherein
the main memory (120) is a volatile memory, and the auxiliary memory (160) is a non-volatile memory.

8. The electronic device with memory data backup function of any one of claims 1 to 7, wherein
the controller (110) backs up the data stored in the main memory (120) and an operation state of the controller (110) itself to the auxiliary memory (160), by operating by being supplied with the auxiliary electric power.

9. The electronic device with memory data backup function of claim 2, wherein
the power supply monitoring unit (150) detects as an abnormal change in electric power, when the main electric power is not supplied, or the main electric power is above or below a reference voltage.

10. The electronic device with memory data backup function of claim 4, wherein the controller (110) includes:
a first controller configured to perform an operation by using data stored in the main memory (120); and
a second controller configured to back up the data stored in the main memory (120) and an operation state of the first controller itself to the auxiliary memory (160), when receiving the abnormality detection signal.

11. The electronic device with memory data backup function of claim 10, wherein
the second controller, when receiving the normality detection signal, restores the data backed up in the auxiliary memory (160) to the main memory (120), and enables the first controller to continuously perform an operation in a state before backup by providing the first controller with the stored operation state.
